# EUROPÄISCHE PATENTSCHRIFT

(11) **EP 0 693 672 B1**
(45) Veröffentlichungstag und Bekanntmachung des Hinweises auf die Patenterteilung: **18.12.1996**
(21) Anmeldenummer: 94110254.3
(22) Anmeldetag: 01.07.1994
(51) Int. Cl.: G01D 5/18, G01B 7/00, H01L 29/84

(54) **Längen- oder Winkelmesseinrichtung**
Length or angle measuring device
Dispositif de mesure de longueurs ou d'angles

(43) Veröffentlichungstag der Anmeldung: 24.01.1996
(60) Teilanmeldung: 96109083.4
(73) Patentinhaber: Dr. Johannes Heidenhain GmbH, D-83292 Traunreut (DE)
(72) Erfinder: Speckbacher, Peter, Dr., D-84558 Kirchweidach (DE)

(56) Entgegenhaltungen:
- EP-A- 0 395 844
- EP-A- 0 442 329
- EP-A- 0 526 730

## Beschreibung

Die Erfindung bezieht sich auf eine Längen- oder Winkelmeßeinrichtung mit einem Substrat als Maßverkörperung, welches Halbleiter-Bauelemente als Meßteilung trägt und von einer Steuer-Elektrode abgetastet wird.

Meßsysteme sind als optisch, optoelektronisch, magnetisch, kapazitiv oder induktiv arbeitende Vorrichtungen hinlänglich bekannt. Beispielhaft für die Kategorie der optoelektronischen Vorrichtungen seien die EP-0 395 844-A2 und EP-0 526 730-A1 der Anmelderin genannt.

Aus der EP- 0 588 383-A2 ist eine Positionsmeßeinrichtung bekannt, die den Halbleiter-Effekt dadurch ausnutzt, daß ein positionsabhängiges Signal erzeugt wird, wobei der Überdeckungsgrad eines beweglichen, ein Kraftfeld produzierenden Elementes gegenüber einer aktiven Oberfläche eines anderen Elementes positionsbestimmend ist.

Aus der EP-0 442 329-A1 ist eine Positionsmeßeinrichtung bekannt, die ebenfalls den Halbleiter-Effekt ausnutzt und bei der eine Abtastelektrode mit schleifendem Kontakt über ein Substrat geführt wird um die Position zu bestimmen.

Aufgabe der vorliegenden Erfindung ist es, eine besonders vorteilhafte Meßeinrichtung zu schaffen, die den Feldeffekt in Halbleitern ausnützt.

Diese Aufgabe wird gelöst durch eine Längen- oder Winkelmeßeinrichtung mit den Merkmalen des Anspruches 1.

Vorteilhafte Ausführungsformen der erfindungsgemäßen Längen- oder Winkelmeßeinrichtung ergeben sich aus den abhängigen Ansprüchen.

Die besonderen Vorteile dieses Meßsystemes liegen in der Anwendung der Silizium-Technologie, was beispielsweise eine hohe Reproduzierbarkeit bei der Herstellung durch den hohen Reinheitsgrad des Si zur Folge hat. Zudem gewährleisten die bekannten Prozesse in der Halbleitertechnologie eine hohe Integrationsdichte und kleinste Strukturen im Submicronbereich. Die Verwendung von Feldeffekt-Transistor-Bauelementen als Meßteilung, die als aktivierbare Bauelemente bei der Positionsmessung elektrische Impulse erzeugen, ermöglicht die direkte Weiterverarbeitung dieser elektrischen Signale. Aufgrund der erfindungsgemäßen Ausgestaltung mit Referenzmarken läßt sich die Verfahrrichtung einfach ermitteln.

Mit Hilfe der Zeichnungen soll die Erfindung anhand mehrerer Ausführungsbeispiele noch näher erläutert werden.

Es zeigt
- Figur 1: eine Prinzipskizze;
- Figur 2: eine schematisierte Ausführungsform;
- Figur 3: eine Auswerteschaltung;
- Figur 4: eine Prinzipdarstellung eines Feldeffekt-Transistors;
- Figur 5: eine Meßeinrichtung mit Referenzmarken und ein Impulsdiagramm;
- Figur 6: eine Variante der Meßeinrichtung gemäß Figur 5;
- Figur 7: eine weitere Variante;
- Figur 8: eine Variante mit mehreren Referenzmarken und mehreren Steuer-Elektroden;
- Figur 9: eine unsymmetrische Impulsfolge und
- Figur 10: eine mehrspurige Meßeinrichtung als codierte Lagemeßeinrichtung.

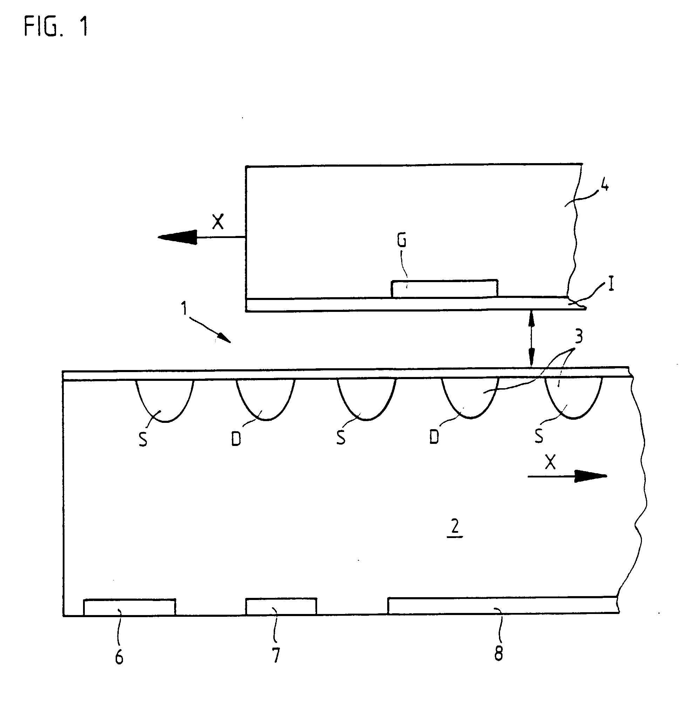

Die in Figur 1 dargestellte Prinzipskizze eines Längen- oder Winkelmeßsystemes 1 zeigt ausschnittsweise eine Maßverkörperung 2, die eine periodische Meßteilung 3 trägt. Die Meßteilung 3 besteht aus S-Polen (source) und D-Polen (drain) einer Reihe von Feldeffekt-Transistor-Bauelementen S und D, die als periodische Meßteilung 3 abwechselnd in Meßrichtung aneinandergereiht sind.

Diese Aneinanderreihung von Source- und Drain-Bereichen S und D wird bei Relativbewegungen zwischen der Maßverkörperung 2 und einer Abtasteinrichtung 4 abgetastet. Die Abtastung erfolgt mittels einer Steuer-Elektrode (gate) G, die sich in der Abtasteinrichtung 4 befindet. Die Steuer-Elektrode G bildet einen elektronenleitenden Kanal und überbrückt die Source- und Drain-Bereiche S und D der Meßteilung 3 und vervollständigt bzw. aktiviert damit jeweils die die Meßteilung 3 bildenden Feldeffekt-Transistor-Bauelemente S und D zu einem Feldeffekt-Transistor SDG.

Die Wirkungsweise des Meßsystems 1 beruht auf dem Schalten von einzelnen Transistor-Bauelementen, wobei abwechselnd die Source- und Drain-Bereiche S und D des Transistors periodisch als Maßverkörperung 2 in Silizium eindiffundiert sind und wobei auch ein anderes Halbleitersubstrat als Si denkbar ist.

Im Folgenden soll die Wirkungsweise anhand einer Prinzipdarstellung eines Feldeffekt-Transistors erläutert werden, da dieser Effekt für die Funktion der erfindungsgemäßen Meßeinrichtung anschaulich und wesentlich ist.

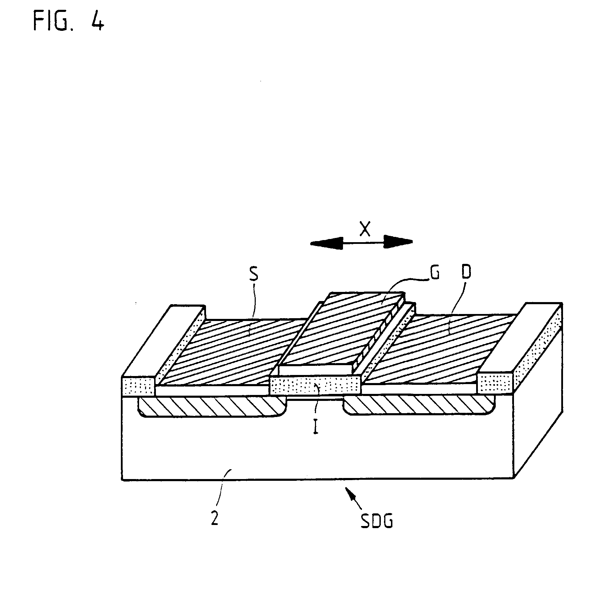

In Figur 4 ist beispielhaft ein einzelner Transistor SDG dargestellt, wobei das Substrat der Maßverkörperung 2 p-leitendes Silizium ist. Die Source- und Drain-Bereiche S und D sind stark n-dotiert. Die - beim Meßsystem bewegliche - einzelne Gateelektrode G (Metall) ist elektrisch durch einen Isolator I vom Substrat 2 getrennt und zur Meßteilung 3 relativ beweglich. Bei geeigneter Gatespannung kann der Bereich unter dem Gate G zwischen Source S und Drain D mit Elektronen verarmt bzw. angereichert werden. Bei Anlegen einer genügend hohen positiven Gatespannung entsteht zwischen Source S und Drain D ein elektronenleitender Kanal, die "Inversionsschicht", der Transistor SDG wird in diesem Fall in Sättigung betrieben. Der Betrieb des Meßsystems ist außer im Sättigungsbereich aber auch im Verstärkungsbereich des Transistors SDG möglich, was später noch ausführlich abgehandelt wird.

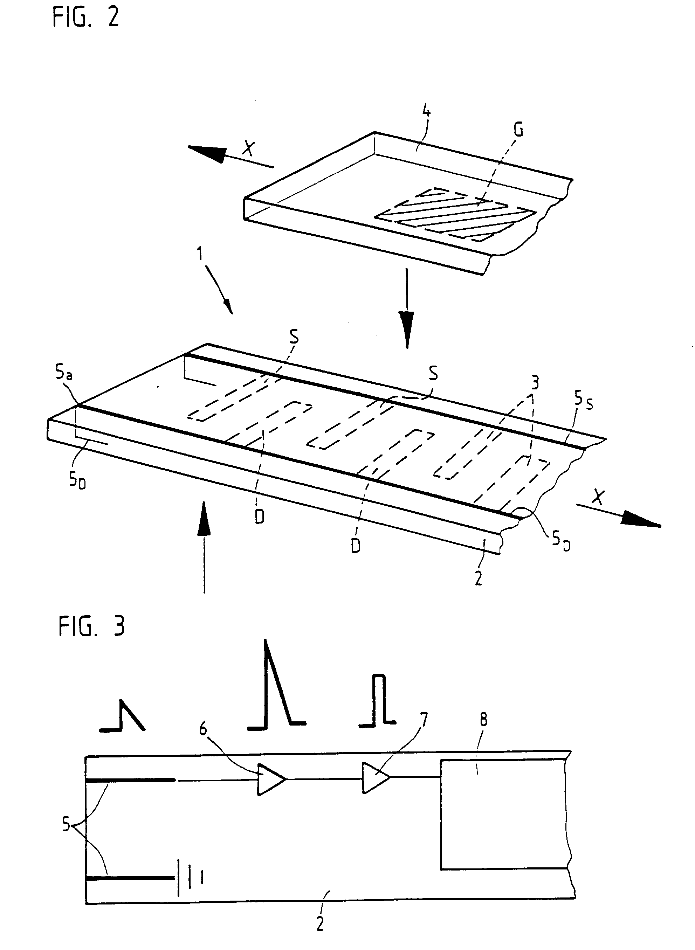

In Figur 2 ist eine mögliche, schematisierte Ausführungsform gezeigt. Die Bezugszeichen gemäß Figur 1 werden beibehalten, jedoch soll durch die perspektivische Darstellung der Bezug zu herkömmlichen Längen- oder Winkelmeßeinrichtungen erleichtert werden.

Die Maßverkörperung 2 wird beschrieben durch periodisches aber abwechselndes Aneinanderreihen von Source- und Drain-Bereichen S und D in Meßrichtung. Die Source- und Drainimplantation ist in der Halbleitertechnologie ein Standardprozeß, wobei Strukturen im Submicronbereich Stand der Technik sind. Als Beispiele für Aneinanderreihen von Transistoren seien Flüssigkeitsanzeigen "LCD" oder "CCD"-Zeilenkameras genannt. Die Source- und Drainimplantation beeinflußt die Oberflächenplanheit der Maßstabsoberfläche nicht. Zur Passivierung und Erhöhung der mechanischen Belastbarkeit kann die Maßstabsoberfläche mit SiO₂ oder Si₃N₄ belegt werden.

Die Abtasteinheit 4 besteht ebenfalls aus Silizium, in welches eine oder mehrere Gateelektroden G integriert sind. Möglich ist auch ein Tieferlegen der Gatestruktur zum Beispiel durch selektive Ätzprozesse in Silizium. Die Abtasteinheit 4 und der Maßstab 2 können in Kontakt oder in einem definiertem Abstand gegeneinander geführt werden. Bei Bewegung von Abtasteinheit 4 (Gateelektrode G) und Maßstab 2 in einem definiertem Abstand muß je nach Substratdotierung und angelegter Gatespannung ein definierter Abstand eingehalten werden, um den elektronenleitenden Kanal zu erhalten.

Der Körper 2 wird als Teilabschnitt einer Maßverkörperung betrachtet, die bereits in den Figuren 1 und 2 gezeigt ist. Zwischen zwei dotierten Bereichen S und D, die zwei Pole eines Feldeffekt-Transistors SDG darstellen, wird ein Bereich plaziert, der das Gatter (gate) G des vorgenannten Transistors SDG bildet.

Ein weiterer nennenswerter Vorteil des Gegenstandes der Erfindung ist folgender:

Durch die Verwendung von Transistoren SDG als aktivierbare Bauelemente zur Längenmessung, können elektrische Pulse direkt weiter verarbeitet werden. Hierzu können zum Beispiel durch anisotrope Ätzprozesse in Silizium, die elektrischen Verbindungen von aktiver Maßstabsoberfläche und weiterverarbeitender Elektronik auf der Rückseite des Maßstabes 2 durch in Gräben 5a tiefergelegte Leiterbahnen 5 hergestellt werden. Auf der Rückseite des Maßstabsubstrates 2 können wahlweise Bauelemente für die Signalverarbeitung (Verstärker 6, Signalvervielfachung 7) und die Ausleseeinheit 8 (z.B. optische LCD-Anzeige) integriert sein. Für den Herstellungsprozeß sind sogenannte "batch" Prozesse denkbar, um hohe Stückzahlen zu erreichen. Hierbei werden auf ein und demselben Substrat eine möglichst große Zahl von identischen Meßsystemen 1 gleichzeitig hergestellt.

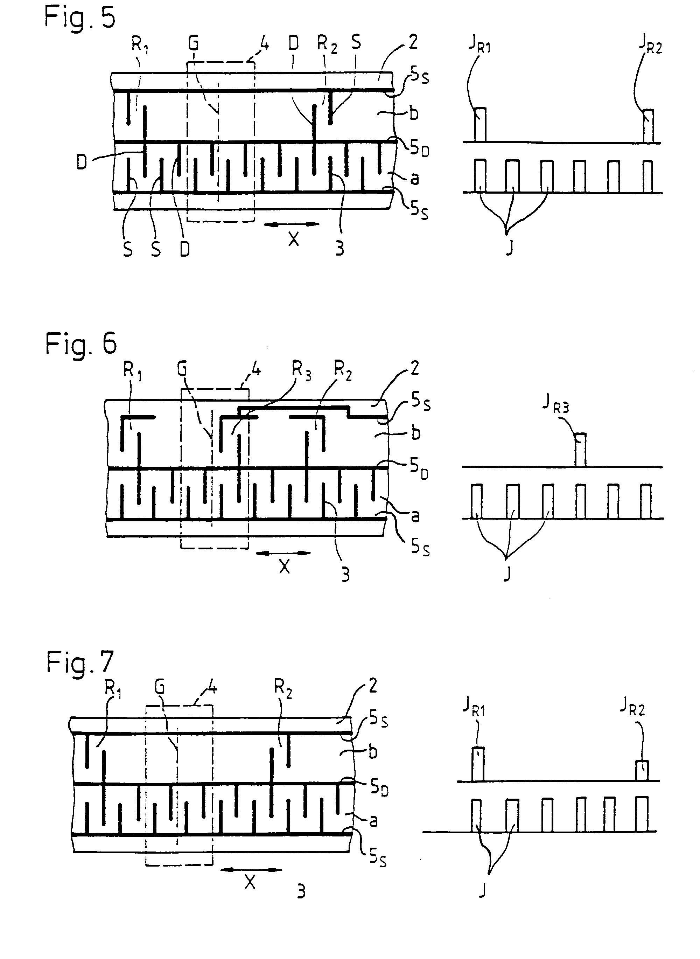

In den Figuren 5 bis 10 ist jeweils in stark schematisierter Darstellung eine vorteilhafte Ausführungsform gezeigt, deren Beschreibung nun folgt. Dabei liegt jeweils die Darstellungsweise in den Figuren 1 und 2 zugrunde, so daß auf die flächige Darstellung der Source- und Drain-Bereiche und der Steuer-Elektrode zugunsten der einfacheren Strichdarstellung verzichtet wurde.

Figur 5 zeigt eine Maßverkörperung 2, auf deren Substrat zwei Spuren a und b angeordnet sind. Spur a weist in Meßrichtung X abwechselnd Source- und Drain-Bereiche S und D auf, die sich jeweils von einer gemeinsamen Sammelleitung 5_{S} bzw. 5_{D} senkrecht zur Meßrichtung X erstrecken und die eine Inkremental-Teilung als Meßteilung 3 bilden.

In der Spur b befinden sich an ausgewählten Orten - in gleicher Weise wie die Meßteilung 3 auf dem Substrat 2 aufgebracht - Source- und Drain-Bereiche S und D, die zwei Referenzmarken R₁ und R₂ bilden.

Mit gestrichelten Linien ist eine Abtasteinrichtung 4 gezeigt, die eine Steuer-Elektrode G beinhaltet.

Bei Relativbewegungen von Substrat 2 und Abtasteinrichtung 4 in Meßrichtung X entstehen beim Überfahren der Source- und Drain-Bereiche S und D Impulse J (von der inkrementalen Meßteilung 3) und J_{R1}, J_{R2} (von den Referenzmarken R₁ und R₂). Das entsprechende Impulsdiagramm ist vereinfacht im rechten Teil von Figur 5 gezeigt.

Figur 6 zeigt eine ähnliche Anordnung wie Figur 5. Dort sind in gleicher Weise drei Referenzmarken R₁, R₂, R₃ auf dem Substrat 2 aufgebracht. Aus betriebstechnischen Gründen sollen jedoch nicht alle Referenzmarken R₁, R₂ und R₃ ausgewählt werden. Für den hier beschriebenen Fall soll lediglich eine Referenzmarke, nämlich R₃ aktiviert werden. Das kann durch eine entsprechende Verschaltung der Referenzmarken R₁, R₂, R₃ geschehen. In diesem Beispiel wird die Source-Sammelleitung 5_{S} zur Referenzmarke R₃ geführt, die Source-Verbindung zu den Referenzmarken R₁ und R₂ ist unterbrochen. Dadurch können diese beim Überfahren mit der Steuer-Elektrode G nicht aktiviert werden. Aus dem nebenstehenden Impulsdiagramm wird dies auch ersichtlich.

Eine Referenzmarkenauswahl kann auch dadurch erfolgen, daß bei der Auswertung verschiedene Referenzmarken in unterschiedlichen Verstärkungsbereichen betrieben werden. Dies ist mit Hilfe von Figur 7 dargestellt, und insbesondere aus dem zugehörigen Impulsdiagramm ersichtlich. Die unterschiedliche Höhe der Impulse J_{R1} und J_{R2} entsteht durch den Betrieb in unterschiedlichen Verstärkungsbereichen. Durch entsprechende Schwellwertschalter oder dergleichen, kann eine Referenzmarkenauswahl erfolgen.

Das gleiche Bild ergibt sich, wenn die verschiedenen Referenzmarken mit unterschiedlichen Vorspannungen ihrer Source- und Drain-Bereiche betrieben werden.

Selbstverständlich müssen dazu die Sammelleitungen zu den Referenzmarken unterbrochen sein. Dieses Ausführungsbeispiel wird aber nicht zeichnerisch dargestellt, weil das Impulsdiagramm dem aus Figur 7 gleichen würde.

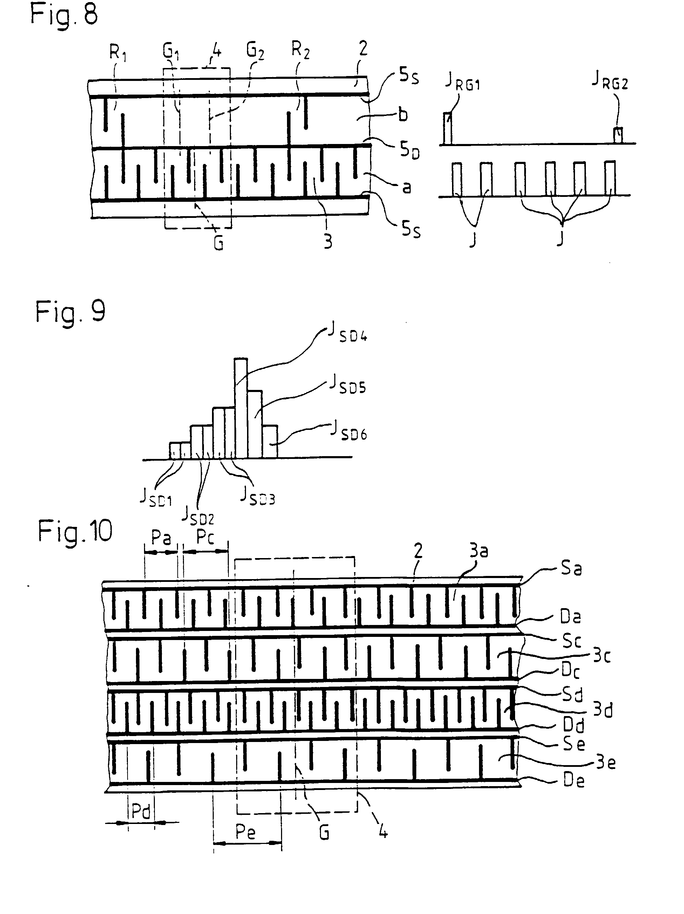

Eine andere Lösung zur Auswahl von Referenzmarken R₁ oder R₂ aus einer beliebigen Anzahl von Referenzmarken ist im Ausführungsbeispiel gemäß Figur 8 dargestellt.

In der Abtasteinrichtung 4 sind außer der Steuer-Elektrode G für die Meßteilung 3 noch zwei weitere Steuer-Elektroden G1 und G2 vorgesehen. Mit diesen Steuer-Elektroden G1 und G2 können gezielt einzelne Referenzmarken R₁ bzw. R₂ ausgewählt werden. Auch bei dieser Ausführungsform können die Steuerspannungen, die Vorspannungen der Source- und Drain-Bereiche, die Verstärkungsbereiche beliebig variiert werden, auch Kombinationen dieser Variationen sind selbstverständlich möglich. Das Impulsdiagramm kann dem dargestellten entsprechen. Die durch den räumlichen Versatz der Steuer-Elektroden G1 und G2 auftretenden Lageänderungen der Impulse können gezielt genutzt werden, aber sie können auch durch entsprechenden Versatz der Referenzmarken auf dem Substrat wieder ausgeglichen werden.

Eine weitere sehr vorteilhafte Möglichkeit zur Auswertung von Referenzmarken gemäß der Erfindung wird anhand eines Impulsdiagrammes in Figur 9 veranschaulicht.

Eine nicht dargestellte Referenzmarke weist dazu mehrere Source- und Drain-Bereiche auf. Hierdurch unterscheidet sich ihr Aufbau von dem der bisher betrachteten Referenzmarken.

Einige der Source- und Drain-Bereiche können schaltungstechnisch zusammengefaßt werden, aber es kann zwischen oder neben zusammengefaßten Source- und Drain-Bereichen auch ein einzelner Source- und Drain-Bereich angeordnet sein.

Analog zu den vorbeschriebenen Ausführungsbeispielen können sowohl die zusammengefaßten, als auch die einzelnen Source- und Drain-Bereiche mit unterschiedlichen Vorspannungen und/oder in unterschiedlichen Verstärkungsbereichen betrieben werden. Ein derartiger Betrieb kann eine Impulsfolge erzeugen, wie sie in Figur 9 dargestellt ist. Dabei bedeutet J_{SD1}, daß ein Impuls vorliegt, der aus zwei zusammengefaßten Source- und Drain-Bereichen einer ersten Vorspannung (oder eines ersten Verstärkungsbereiches) hervorgegangen ist. Der Impuls J_{SD2} ist aus zwei zusammengefaßten Source- und Drain-Bereichen einer zweiten Vorspannung (oder eines zweiten Verstärkungsbereiches) hervorgegangen. Dementsprechend ist der Impuls J_{SD3} aus (wiederum zwei) zusammengefaßten Source- und Drain-Bereichen einer dritten Vorspannung (oder eines dritten Verstärkungsbereiches) hervorgegangen. Daran schließen sich Impulse J_{SD4,} J_{SD5} und J_{SD6} an, die jeweils an einzelnen Source- Drain-Bereichen gewonnen werden, aber mit unterschiedlichen vierten, fünften und sechsten Vorspannungen oder entsprechenden Verstärkungsbereichen betrieben werden.

Wenn erfindungsgemäß eine solche Impulsfolge ausgewertet wird, zeigt sich, daß die Einhüllende eine unsymmetrische Kurve ist. Deren Auswertung kann vorteilhaft zur Erkennung der Richtung herangezogen werden, aus der die so gestaltete Referenzmarke überfahren wurde.

Derartig unsymmetrische Referenzmarken lassen sich besonders vorteilhaft als Grenzlagenschalter verwenden.

Figur 10 zeigt schließlich ein Ausführungsbeispiel, bei dem auf einem Substrat 2 mehrere Spuren a, c, d, e vorgesehen sind. In jeder Spur a, c, d und e befinden sich sich abwechselnde Source- und Drain-Bereiche, die periodisch angeordnet sind und jeweils eine periodische Meßteilung 3a, 3c, 3d und 3e bilden. Diese Meßteilungen 3a, 3c, 3d und 3e sind zwar periodisch, aber jede der Meßteilungen 3a, 3c, 3d und 3e hat eine andere Teilungsperiode Pa, Pc, Pd, Pe.

Bei gemeinsamer Abtastung aller Meßteilungen 3a, 3c, 3d, 3e mit einer einzigen Steuer-Elektrode G in einer Abtasteinrichtung 4 kann aus der Phasenbeziehung der Abtastsignale ein codierter Positionswert gewonnen werden.

Die technische Ausführungsform entspricht beispielsweise vier parallelen Meßeinrichtungen gemäß Figur 2, entsprechend sind die Source- und Drain-Sammelleitungen bezeichnet. Eine Analogie zu den vorstehenden Ausführungsbeispielen ist für den Fachmann ohne weiteres herleitbar, so daß die Grund-Funktionsprinzipien nicht noch einmal erläutert werden müssen.

Zusammengefaßt beruht das beschriebene Meßsystem 1 darauf, das feldinduziert in einem Halbleiter, je nach örtlicher Position der Gateelektrode G, eine elektronenleitende Inversionsschicht ein und ausgeschaltet wird.

Das oben beschriebene System ist unabhängig von optischen Signalen und Bauelementen. Damit ist keine "Alterung" des Meßsystems 1 mit der Zeit zu erwarten (Abbau der Intensitäten von Laserdioden mit langen Betriebszeiten). Das oben beschriebene Meßsystem 1 kann als Längenmeßsystem oder als Winkelmeßsystem ausgeführt werden.

Durch die Verwendung von Silizium sind bekannte Halbleitertechnologien und Prozesse verwendbar, eine Integration von Optik, Elektronik und Mechanik zu einem Mikrosystem ist denkbar.

Silizium hat hervorragende mechanische Eigenschaften, wie zum Beispiel Kratzfestigkeit. Die Reinheit des Kristalls gewährt hohe Reproduzierbarkeit der elektronischen Eigenschaften des Meßsystems.

Bei Verwendung von anderen Halbleitermaterialien sind hohe Grenzfrequenzen der schaltenden Transistoren SDG zu erwarten. Als Beispiel sei ein HEMT ("high-electron-mobility-transistor") Transistor mit einer Schichtstruktur von GaAs/GaALAs erwähnt, wobei Grenzfrequenzen bis 100 GHz erreicht werden.

## Patentansprüche

1. Längen- oder Winkelmeßeinrichtung mit einem Substrat (2) als Maßverkörperung, welches Halbleiter-Bauelemente (S, D) als Meßteilung (3) trägt, die von einer Abtasteinrichtung (4) abgetastet werden, und bei der auf dem Substrat (2) wenigstens eine Spur (a) angeordnet ist, in der die Meßteilung (3) durch eine Vielzahl von in Meßrichtung X periodisch hintereinander angeordneten Source-Bereichen (S) und eine Vielzahl von ebenfalls in Meßrichtung X periodisch hintereinander angeordneten Drain-Bereichen (D) gebildet wird, wobei die Source (S)- und Drain (D)-Bereiche quer zur Meßrichtung X nach Art von Zinken abwechselnd ineinander greifen, und daß zur Abtastung der so gebildeten Meßteilung (3) in der Abtasteinrichtung (4) wenigstens eine Steuer-Elektrode (G) in Meßrichtung X, parallel zur Oberfläche in konstantem Abstand zum Substrat (2) verschiebbar angeordnet ist sowie ferner eine weitere Spur (b) auf dem Substrat (2) angeordnet ist, in welcher durch abwechselnde Anordnung von Source (S)- und Drain (D)-Bereichen wenigstens eine Referenzmarke (R) gebildet wird.

2. Längen- oder Winkelmeßeinrichtung nach Anspruch 1, wobei mehrere Referenzmarken (R₁...Rₙ) auf dem Substrat (2) angeordnet sind, von denen eine oder mehrere durch entsprechende Verschaltung auswählbar sind.

3. Längen- oder Winkelmeßeinrichtung nach Anspruch 1, wobei mehrere Referenzmarken (R₁...Rₙ) auf dem Substrat (2) angeordnet sind, die durch Betreiben in unterschiedlichen Verstärkungsbereichen auswählbar sind.

4. Längen- oder Winkelmeßeinrichtung nach Anspruch 1, wobei mehrere Referenzmarken (R₁...Rₙ) auf dem Substrat (2) angeordnet sind, die durch unterschiedliche Vorspannungen der zugehörigen Source- und Drain-Bereiche (SD_{R1}...SD_{Rn}) auswählbar sind.

5. Längen- oder Winkelmeßeinrichtung nach Anspruch 1, wobei mehrere Referenzmarken (R_{1G}...R_{nG}) auf dem Substrat (2) angeordnet sind, die durch verschiedene Steuer-Elektroden (G₁...Gₙ) in der Abtasteinrichtung (4 ) auswählbar sind.

6. Längen- oder Winkelmeßeinrichtung nach Anspruch 3 oder 4, wobei mehrere Referenzmarken (R₁...Rₙ) auf dem Substrat (2) angeordnet sind, wobei jede Referenzmarke (R₁...Rₙ) über mehrere Source- und Drain-Bereiche (SD₁...SDₙ) verfügt, welche mit unterschiedlichen Vorspannungen oder in unterschiedlichen Verstärkungsbereichen arbeiten und die dadurch auswählbar sind.

7. Längen- oder Winkelmeßeinrichtung nach Anspruch 6, wobei zwei Referenzmarken (R₁...R₂) auf dem Substrat (2) angeordnet sind, die zur Richtungserkennung beim Überfahren mit der Steuerelektrode (G) in der Abtasteinrichtung (4) eine Unsymmetrie bei der Auswertung erzeugen.

8. Längen- oder Winkelmeßeinrichtung nach einem der Ansprüche 1 bis 7, wobei die Referenzmarken (R) als individuelle Steuermarken wirken, beispielsweise als Grenzlagenschalter.

9. Längen- oder Winkelmeßeinrichtung nach Anspruch 1, wobei in mehreren Spuren (a, c, d, e) periodische Meßteilungen (3a, 3c, 3d, 3e) angeordnet sind, die unterschiedliche Teilungsperioden (Pa, Pc, Pd, Pe) aufweisen, durch deren gemeinsame Abtastung eine codierte Lagemeßeinrichtung gebildet wird.

10. Längen- oder Winkelmeßeinrichtung nach Anspruch 1, wobei zwischen den Source- und Drain-Bereichen (S, D) und der Steuer-Elektrode (G) ein Isolator angeordnet ist.

11. Längen- oder Winkelmeßeinrichtung nach Anspruch 1, wobei das Substrat (2) die elektrischen Auswerteelemente wie Verstärker (6), Vervielfachungsschaltung (7) und die Anzeige (8) enthält.

12. Vorrichtung nach Anspruch 11, wobei die Auswerteelemente (6, 7, 8) mit den Source- und Drain-Bereichen (S, D) innerhalb des Substrates (2) elektrisch verbunden sind.

13. Vorrichtung nach Anspruch 12, wobei durch anisotropes Ätzen von Gräben (5a) in das Substrat (2) und galvanische Leiterbahn-Verbindungen (5) in den Gräben (5a) die Verbindung der Auswerteelemente (6, 7, 8) mit den Source- und Drain-Bereichen (S, D) erfolgt.

## Claims

1. Length or angle measuring device with a substrate (2) as measurement body bearing semiconductor components (S, D) as measurement graduation (3), which are scanned by a scanning system (4), and in which at least one track (a) is arranged on the substrate (2) in which the measurement graduation (3) is formed by a plurality of source regions (S) arranged periodically one behind the other in the direction of measurement X and a plurality of drain regions (D) also arranged periodically one behind the other in the direction of measurement X, said source (S) and said drain (D) regions meshing alternately into one another transversely to the direction of measurement X in the manner of tines, and that for scanning the measurement graduation (3) thus formed in the scanning system (4), at least one control electrode (G) is arranged in the direction of measurement X to be displaceable parallel to the surface at a constant distance from the substrate (2), and also a further track (b) is arranged on the substrate (2) in which at least one reference mark (R) is formed by alternating arrangement of the source (S) and drain (D) regions.

2. Length or angle measuring device according to Claim 1, wherein several reference marks (R₁...Rₙ) are arranged on the substrate (2), of which one or more may be selected by appropriate circuiting.

3. Length or angle measuring device according to Claim 1, wherein several reference marks (R₁...Rₙ) are arranged on the substrate (2), which may be selected by operating in different amplification ranges.

4. Length or angle measuring device according to Claim 1, wherein several reference marks (R₁..Rₙ) are arranged on the substrate (2), which may be selected by different biases of the associated source and drain regions (SD_{R1}...SD_{Rn}).

5. Length or angle measuring device according to Claim 1, wherein several reference marks (R_{1G}...R_{nG}) are arranged on the substrate (2), which may be selected by different control electrodes (G₁...Gₙ) in the scanning system (4).

6. Length or angle measuring device according to Claim 3 or 4, wherein several reference marks (R₁...Rₙ) are arranged on the substrate (2), each reference mark (R₁...Rₙ) having several source and drain regions (SD₁...SDₙ) available, which operate with different biases or in different amplification ranges and may be selected thereby.

7. Length or angle measuring device according to Claim 6, wherein two reference marks (R₁...R₂) are arranged on the substrate (2), which generate asymmetry during evaluation for recognition of the direction during crossing with the control electrode (G) in the scanning system (4).

8. Length or angle measuring device according to one of Claims 1 to 7, wherein the reference marks (R) act as individual control marks, e.g. as boundary position switches.

9. Length or angle measurement device according to Claim 1, wherein in several tracks (a, c, d, e) periodic measurement graduations (3a, 3c, 3d, 3e) are arranged which have different graduation periods (Pa, Pc, Pd, Pe), a coded position measuring device being formed by their joint scanning.

10. Length or angle measuring device according to Claim 1, wherein an insulator is arranged between the source and drain regions (S, D) and the control electrode (G).

11. Length or angle measuring device according to Claim 1, wherein the substrate (2) contains the electrical evaluation elements such as amplifier (6), multiply circuit (7) and the display (8).

12. Device according to Claim 11, wherein the evaluation elements (6, 7, 8) are electrically connected to the source and drain regions (S, D) inside the substrate (2).

13. Device according to Claim 12, wherein the evaluation elements (6, 7, 8) are connected to the source and drain regions (S, D) by anisotropic etching of troughs (5a) into the substrate (2) and electrical strip conductor connections (5) in the troughs (5a).

## Revendications

1. Dispositif de mesure de longueurs ou d'angles avec comme mesure matérialisée, un substrat (2) qui porte comme graduation de mesure (3) des composants semi-conducteurs (S, D) qui sont palpés par un dispositif de palpage (4) et avec au moins une piste (a) disposée sur le substrat (2), sur laquelle la graduation de mesure (3) est formée de plusieurs zones de source (S) disposées périodiquement les unes à la suite des autres dans la direction de mesure (X) et de plusieurs zones de drain (D) également disposées périodiquement les unes à la suite des autres dans la direction de mesure (X), les zones de source (S) et de drain (D) s'interpénétrant alternativement, transversalement à la direction de mesure X, à la manière de dents, au moins une électrode (G) de commande étant montée coulissante dans la direction de mesure X, parallèlement à la surface, à distance constante du substrat, dans le dispositif de palpage (4) à des fins de palpage de la graduation de mesure (3) ainsi formée, et une piste (b) supplémentaire, sur laquelle au moins un repère de référence (R) est formé par un agencement alterné de zones de source (S) et de zones de drain (D), étant disposée sur le substrat (2).

2. Dispositif de mesure de longueurs et d'angles selon la revendication 1, dans lequel plusieurs repères de référence (R₁...Rₙ), parmi lesquels un ou plusieurs repères peuvent être sélectionnés par commutation adaptée, sont disposés sur le substrat (2).

3. Dispositif de mesure de longueurs et d'angles selon la revendication 1, dans lequel plusieurs repères de référence (R₁...Rₙ) qui peuvent être sélectionnés par fonctionnement dans différentes plages d'amplification, sont disposés sur le substrat (2).

4. Dispositif de mesure de longueurs et d'angles selon la revendication 1, dans lequel plusieurs repères de référence (R₁...Rₙ) qui peuvent être sélectionnés par des tensions de polarisation différentes des zones de source (S) et de drain (D) correspondantes, sont disposés sur le substrat (2).

5. Dispositif de mesure de longueurs et d'angles selon la revendication 1, dans lequel plusieurs repères de référence (R₁...Rₙ) qui peuvent être sélectionnés à l'aide de plusieurs électrodes de commande (G₁...Gₙ) dans le dispositif de palpage (4), sont disposés sur le substrat (2).

6. Dispositif de mesure de longueurs et d'angles selon la revendication 3 ou 4, dans lequel plusieurs repères de référence (R₁...Rₙ) sont disposés sur le substrat (2), chaque repère de référence (R₁...Rₙ) présentant plusieurs zones de source et de drain (SD₁...SDₙ) qui travaillent avec des tensions de polarisation différentes ou dans des plages d'amplification différentes et peuvent être sélectionnés de cette manière.

7. Dispositif de mesure de longueurs et d'angles selon la revendication 6, dans lequel deux repères de référence (R₁...R₂) sont disposés sur le substrat (2), repères qui, aux fins de détecter la direction, produisent une dissymétrie au moment du traitement lorsqu'ils sont palpés par l'électrode de commande (G) dans le dispositif de palpage (4).

8. Dispositif de mesure de longueurs et d'angles selon l'une revendications 1 à 7, dans lequel les repères de référence (R) agissent en tant repères de commande distincts, par exemple en tant qu'interrupteurs de fin de course.

9. Dispositif de mesure de longueurs et d'angles selon la revendication 1, dans lequel des graduations de mesure (3a, 3c, 3d, 3e) périodiques, avec des périodes de graduation (Pa, Pc, Pd, Pe) différentes, sont disposées dans plusieurs pistes (a, c, d, e) et forment par lecture simultanée un dispositif de mesure de position à codage.

10. Dispositif de mesure de longueurs et d'angles selon la revendication 1, dans lequel un isolateur est disposé entre les zones de source et de drain (S, D) et l'électrode de commande (G).

11. Dispositif de mesure de longueurs et d'angles selon la revendication 1, dans lequel le substrat (2) contient les éléments électriques de traitement tels qu'amplificateurs (6), circuit multiplicateur (7) et affichage (8).

12. Dispositif de mesure de longueurs et d'angles selon la revendication 11, dans lequel les éléments de traitement (6, 7, 8) sont reliés électriquement aux zones de source et de drain (S, D) à l'intérieur du substrat (2).

13. Dispositif de mesure de longueurs et d'angles selon la revendication 12, dans lequel la liaison entre les éléments de traitement (6, 7, 8) et les zones de source et de drain (S, D) est réalisée par des sillons (5a) dans le substrat, obtenus par attaque anisotrope, et par des pistes de liaison (5) galvaniques dans les sillons (5a).
